Europäisches Patentamt

**(19)** European Patent Office

Office européen des brevets

**(11)** Publication number : **0 479 304 B1**

**(12)** # EUROPEAN PATENT SPECIFICATION

**(45)** Date of publication of patent specification :
**12.07.95 Bulletin 95/28**

**(51)** Int. Cl.⁶ : **G09G 3/36**

**(21)** Application number : **91116950.6**

**(22)** Date of filing : **04.10.91**

**(54)** Power source apparatus for driving liquid crystal display.

**(30)** Priority : **05.10.90 JP 266365/90**

**(43)** Date of publication of application :
**08.04.92 Bulletin 92/15**

**(45)** Publication of the grant of the patent :
**12.07.95 Bulletin 95/28**

**(84)** Designated Contracting States :
**DE FR GB**

**(56)** References cited :
**EP-A- 0 314 084**
**US-A- 4 769 639**

**(73)** Proprietor : **KABUSHIKI KAISHA TOSHIBA**
**72, Horikawa-cho**
**Saiwai-ku**
**Kawasaki-shi Kanagawa-ken 210 (JP)**

Proprietor : **TOSHIBA MICRO-ELECTRONICS**
**CORPORATION**
**25-1, Ekimaehoncho**
**Kawasaki-ku, Kawasaki-shi (JP)**

**(72)** Inventor : **Arakawa, Takashi, c/o Intellectual**
**Property Div.**
**Kabushiki Kaisha Toshiba,**
**1-1 Shibaura 1-chome**
**Minato-ku, Tokyo 105 (JP)**
Inventor : **Motegi, Hiroyuki, c/o Intellectual**
**Property Div.**
**Kabushiki Kaisha Toshiba,**
**1-1 Shibaura 1-chome**
**Minato-ku, Tokyo 105 (JP)**

**(74)** Representative : **Lehn, Werner, Dipl.-Ing. et al**
**Hoffmann, Eitle & Partner,**
**Patentanwälte,**
**Postfach 81 04 20**
**D-81904 München (DE)**

## Description

The present invention relates to a liquid crystal display device driven by an alternating current, especially to a power source apparatus which is used for driving a liquid crystal display device and has four intermediate potentials between a maximum potential and a minimum potential.

A liquid crystal display device has an arrangement of a plurality of display dots, which are formed of cross points of a group of segment electrodes and a group of common electrodes. The liquid crystals between the two groups of electrodes are controlled in their crystal arrangement by means of potential difference between the groups of segment electrodes and the group of common electrodes in order to display images.

Such a liquid crystal display device uses a dynamic driving control in which potentials set between the segment electrodes and the common electrodes are generally reversed in polarity for each frame. For such a dynamic driving control, there are generally prepared power sources for providing four intermediate potential levels in addition to a maximum potential power source and a minimum potential power source, the intermediate potential levels being obtained by dividing the potential difference between the maximum potential level and the minimum potential level into four parts. A power source having a suitable potential level is selected in accordance with a display data, and the voltage obtained by the selected potential power source is delivered and applied to the group of segment electrodes and the group of common electrodes.

The four intermediate potential levels between the potential levels set by the maximum potential power source and the minimum potential power source are generated by a voltage dividing circuit which is formed by a combination of resistors.

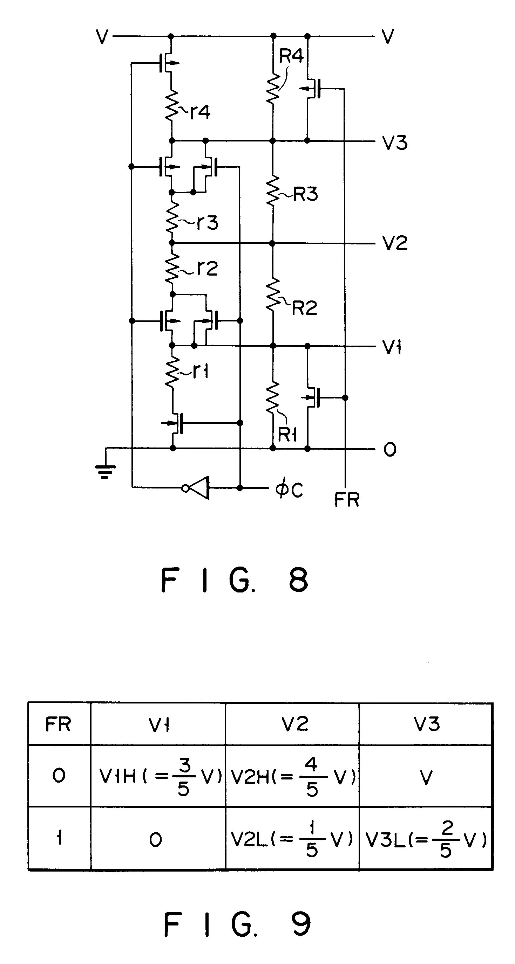

Fig.8 shows a conventionally known power source circuit for driving a liquid crystal display device. This power source circuit is arranged such that any one of terminals V1, V2, and V3 supplies, corresponding to frame signal FR, a power source output having a predetermined potential for A.C.-driving a liquid crystal display device.

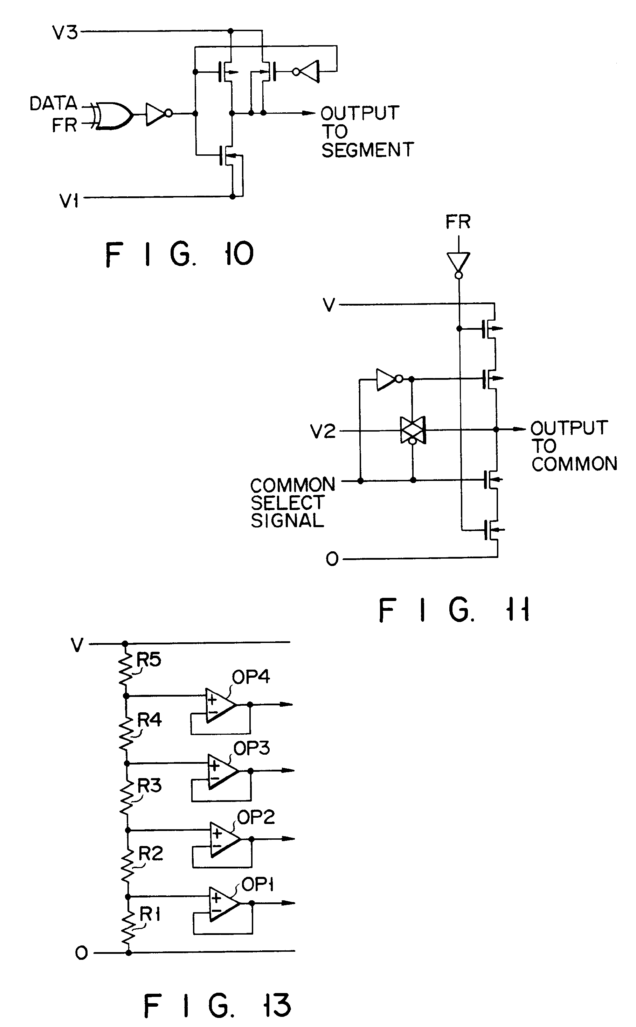

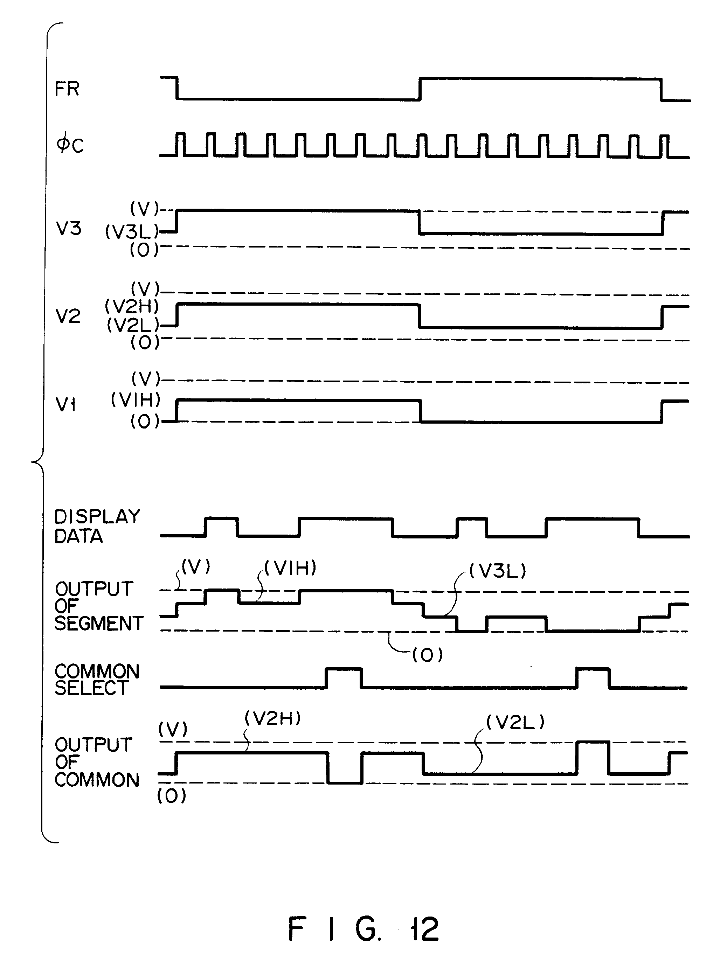

For instance, as apparent from the relationship shown in Fig.9 and the timing chart shown in Fig.12, the maximum potential level "V", the two intermediate levels "V2H" and "V1H", and the minimum potential level "0" are put out when frame signal FR is "0", whereas, when frame signal FR is "1", the maximum potential level "V", the two intermediate potential levels "V3L" and "V2L", and the minimum potential level "0" are put out. These potential level combinations are alternately generated whenever the frame signal changes between "0" and "1". These potential signals are supplied through the segment output level selecting circuit shown in Fig.10 and the common output level selecting circuit shown in Fig. 11 to the segment electrodes and the common electrodes of the liquid crystal display device.

Fig.8 shows a 1/5 pre-biased power source circuit, in which resistors R1 and R4 are each set to 300 KΩ, resistors R2 and R3 to 100 KΩ, resistors r1 and r4 to 30 KΩ, and resistors r2 and r3 to 10 KΩ. The dynamic chart shown in Fig. 12 shows a case of a 1/8 duty in which the number of common outputs is eight. The figure exemplary shows only one segment output among a plurality of segment outputs and only one common output among a plurality of common outputs.

In such a power source circuit, clock signal $\phi c$ formed of a pulse signal indicating a common selection signal switching timing, and lowers the output resistance of the potential dividing circuit at a moment of a common signal switching time so as to increase the response of the liquid crystals. Namely, the charging or discharging time of a capacitance provided in the liquid crystal display device is made short by connecting resistors r1 - r4, which are lower in resistance value than resistors R1 - R4, in parallel with resistors R1 - R4 for dividing voltage V.

However, a large capacitance is required for a liquid crystal display device having a large number of display pixels. Therefore, the output resistance of the voltage dividing circuit must be made sufficiently small, or a satisfactory display quality may not be obtained. However, if the output resistance of the voltage dividing circuit is made small, the problem of increase in power consumption will occur.

Fig. 13 shows a circuit for making small the output resistance of the intermediate potential level power sources. In this circuit, operational amplifiers OP1 through OP4 are used to put out the voltages which are voltage-divided by resistors R1 - R5. This circuit shows a 1/5 pre-biased case, and resistors R1 - R5 are made of resistance element having a same resistance value. However, in such a circuit which uses operational amplifiers, operational amplifiers OP1 - OP4 are always set in active condition, so that the power consumption at the operational amplifier portion is large.

EP-A-0314084 shows a system with the features of the preamble of claim 1.

The object of the present invention is to provide a power source apparatus for driving a liquid crystal display device, in which the output resistance of its voltage dividing circuit can be set sufficiently small, and an image display having a good display quality may be realized.

Another object of the present invention is to provide a power source apparatus in which the output resistance may be set sufficiently small, and the power consumption at the voltage dividing circuit portion will surely be reduced.

According to the present invention, there is provided a power source apparatus for driving a liquid crystal display device, the apparatus comprising a voltage dividing circuit for voltage-dividing a maximum voltage level and a minimum voltage level to generate a plurality of intermediate voltage levels, needed for the liquid crystal display device, with a plurality of operational amplifiers for outputting intermediate voltage levels as outputs V1 to V3, characterized in that

a switching signal (FR) is provided for alternating-current-driving said liquid crystal display device and for setting a first group of said operational amplifiers into an active state and a second group of said operational amplifiers into an inactive state to reduce the circuit power consumption, and the operational amplifiers of the group which is set to the active state are arranged to output to segment electrodes and common electrodes of the liquid crystal display device.

The plural operational amplifiers, which are arranged for providing the plural intermediate potential levels and form the driving power source device, are selectively rendered to be in an inactive state in a period of time when a potential having a potential level corresponding to any one of the operational amplifiers is not used as a liquid crystal driving power source, so that the electric current for operating the operational amplifier reduces. In addition, the presence of the operational amplifiers assures the reduction in output resistance, and the liquid crystal display device will be kept good in quality.

This invention can be more fully understood from the following detailed description when taken in conjunction with the accompanying drawings, in which:

Fig. 1 is a circuit diagram of one embodiment of the present invention for explaining a power source apparatus for driving a liquid crystal display device.

Fig. 2 and Fig. 3 are circuit diagrams for showing concrete examples of an operational amplifier which is a constituent of the above power source device.

Fig. 4 is a circuit diagram for showing concrete example of a bias voltage generator which is a constituent of the above power source device.

Fig. 5 is a diagram of signal waveforms for explaining the operation condition of the above power source device.

Fig. 6 and Fig. 7 are circuit diagrams respectively showing another examples of the operational amplifiers shown in Fig. 2 and Fig. 3.

Fig. 8 is a circuit diagram for showing an example of the conventional power source circuit.

Fig. 9 is a table for explaining a voltage level generating condition of the circuit shown in Fig.8.

Fig. 10 and Fig.11 respectively show circuit examples of a liquid crystal driving portion into which driving power source voltage is supplied.

Fig. 12 is a timing chart for explaining the condition of the liquid crystal driving power source voltage.

Fig. 13 is a circuit diagram for showing another example of the conventional power source circuit.

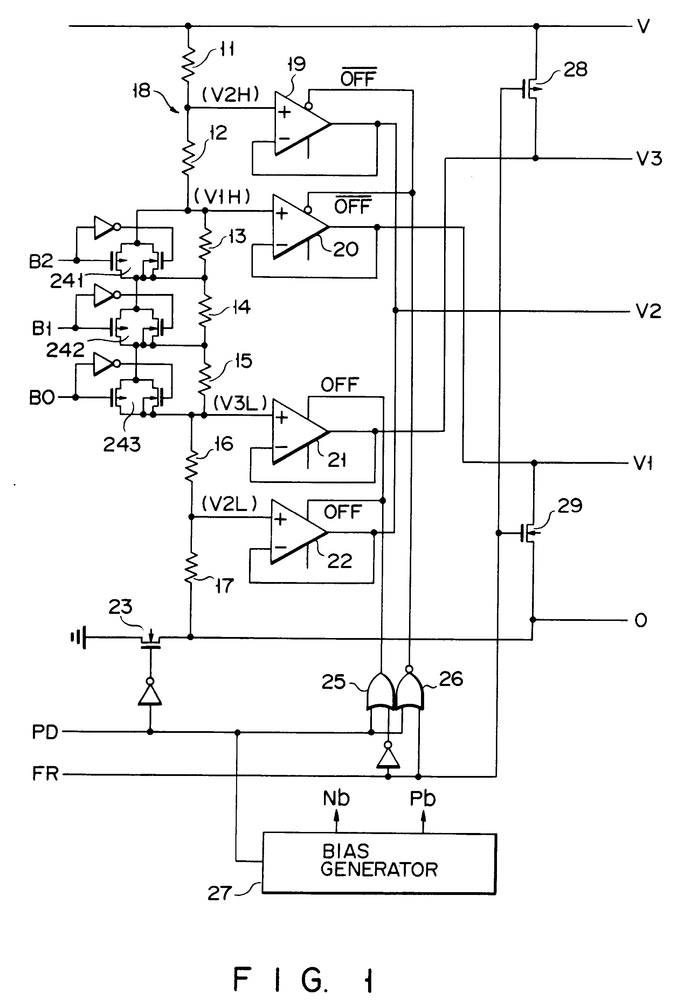

The embodiment shown in Fig. 1 is a power source circuit which is formed of a C-MOS integrated circuit and is applied to a driving device which is incorporated in a one-chip micro computer to drive a liquid crystal display device of the computer. Voltages having different intermediate levels generated by the power source circuit are respectively put out from points V3, V2 and V1. The voltages put out of points V1 and V3 are supplied to a segment output level selecting circuit shown in Fig. 10, whereas the voltage put out of point V2 is supplied to a common output level selecting circuit shown in Fig. 11.

Between a highest potential power source line to which a highest potential V is set and a lowest potential power source line to which a lowest potential 0 is set is connected a voltage dividing circuit 18 which is formed by serially connecting resistors 11 and 12, resistors 13 - 15, and resistors 16 and 17. A voltage having a voltage level "V2H" is put out of a connecting point between resistors 11 and 12, a voltage having a voltage level "V1H" is put out of a connecting point between resistors 12 and 13, a voltage having a voltage level "V3L" is put out of a connecting point between resistors 15 and 16, and a voltage having a voltage level "V2L" is put out of a connecting point between resistors 16 and 17. These voltage outputs are respectively supplied to operational amplifiers 19 to 22. Outputs from operational amplifiers 19 and 22 are put out as voltage V2, an output from operational amplifier 20 is put out as voltage V1, and an output from operational amplifier 21 is put out as voltage V3. The lowest potential power source line is grounded through N-channel MOS transistor 23.

Resistors 13 to 15 are treated as one group. They respectively have parallel connected analogue switching circuits 241 to 243 which are ON-OFF controlled by signals B0 to B2. A composite resistance value of resistors 13 to 15 is set by signals B0 to B2. Signals B0 to B2 are each an output of a processor portion, not shown in any of the drawings, and pre-bias values to be supplied to liquid crystals may be set by a program.

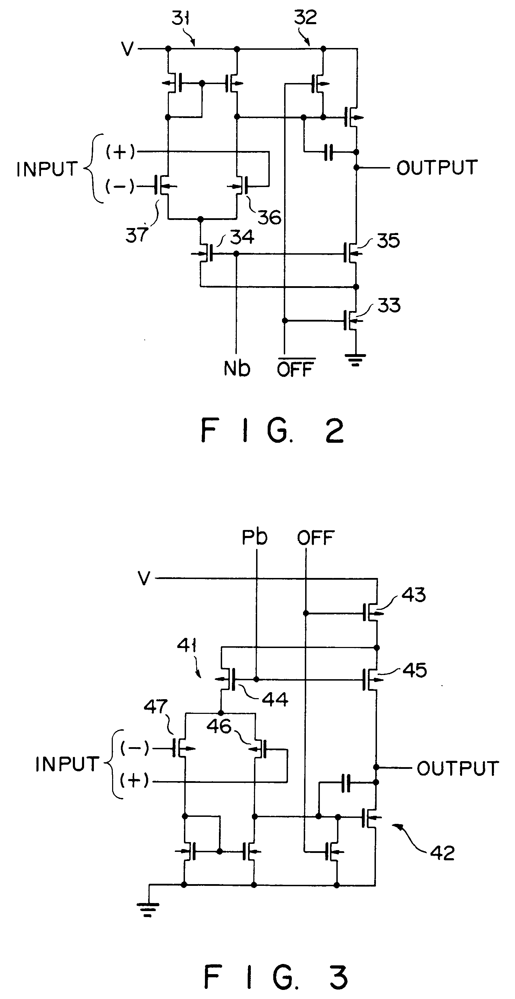

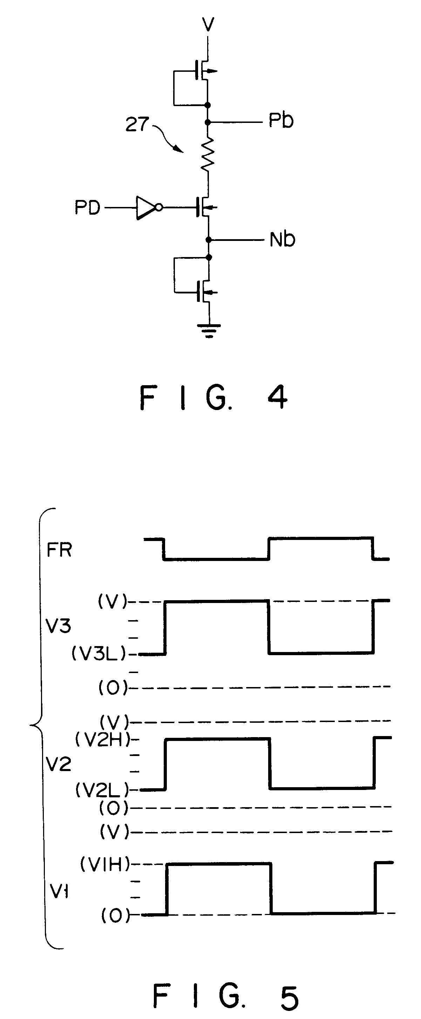

Operational amplifiers 19 and 20 are constructed such that an N-channel MOSFET is used at their respective first stage input portion. Operational amplifiers 21 and 22 are constructed such that a P-channel MOSFET is used at their respective first stage input portion. Fig.2 shows a circuit of an exemplary embodiment for each of operational amplifiers 19 and 20. Fig. 3 shows a circuit of an exemplary embodiment for each of operational amplifiers 21 and 22.

Each of operational amplifiers 19 to 22 has an OFF-signal input terminal, and is rendered to be in an inactive state, where its power consumption becomes zero, by a signal supplied to the OFF-signal input terminal. When the operational amplifiers are rendered to be in the inactive state, their output terminals become high in impedance.

Each of operational amplifiers 19 to 22 has a voltage follower structure in which its output returns to the inverted side (-) input terminal. When these operational amplifiers are in an active state, the voltage level applied to their non-inverted side (+) input is put out as a low output impedance.

The operational amplifier shown in Fig. 2 as an example of each of operational amplifiers 19 and 20 has differential stage 31 and output stage 32, and its electric current is cut off by transistor 33. Its first stage input portion is formed of N-channel MOSFETs 36 and 37. The operational amplifier shown in Fig. 3 as an example of each of operational amplifiers 21 and 22 also has differential stage 41 and output stage 42, and its electric current is cut off by transistor 43. Its first stage input portion is formed of P-channel MOSFETs 46 and 47.

Bias voltage generator 27 generates N-bias voltage Nb and P-bias voltage Pb. It supplies gate bias voltage Nb to N-channel transistors 34 and 35, both of which contribute to a constant current operation in the inside of the operational amplifier shown in Fig. 2 as an example of each of operational amplifiers 19 and 20. It also supplies gate bias voltage Pb to P-channel transistors 44 and 45, both of which contribute to a constant current operation in the inside of the operational amplifier shown in Fig. 3 as an example of each of operational amplifiers 21 and 22. Fig. 4 shows an exemplary embodiment of bias voltage generator 27.

The processor which is not shown in any of the drawings generates power down signal PD for controlling a display power source. Power down signal PD is supplied to the power source circuit shown in Fig. 1. When power down signal PD is "1", N-channel transistor 23 is cut off, and first to fourth operational amplifiers 19 to 22 are rendered to be in an inactive state by means of OR-gate 25 and NOR-gate 26. When power down signal PD is further supplied to bias voltage generator 27, power consumption in generater 27 will be reduced, so that the power consumed by the liquid crystal driving circuit will be reduced.

Power down signal PD becomes "1" under the condition that a display function is not used in the liquid crystal display device. Power consumption in the display system therefore will be reduced by signal PD.

In voltage dividing circuit 18, the resistance value of each of resistors 11, 12, 16 and 17 is set to be R, and the composite resistance value of resistors 13 to 15 is denoted by r. Intermediate voltage levels supplied to non-inverted side (+) input terminals of operational amplifiers 19 to 22 are denoted by "V2H", "V1H", "V3L" and "V2L". Then intermediate voltage levels may be expressed as follows:

$$V2H = \{(3R + r)/(4R + r)\} \cdot V$$
$$V1H = \{(2R + r)/(4R + r)\} \cdot V$$
$$V3L = \{(2R)/(4R + r)\} \cdot V$$
$$V2L = \{R/(4R + r)\} \cdot V$$

The value of the pre-bias may be expressed as follows:

$$\{R/(4R + r)\} \cdot V$$

In the embodiment, "R=200 KΩ", and resistors 13 to 15 are respectively set to 400 KΩ, 200 KΩ and 100 KΩ. An ON-resistance of each of analogue switches 241 to 243 for short-circuiting resistors 13 to 15 is set sufficiently smaller than the resistance values of resistors 13 to 15, so that it is possible to consider it "0". Therefore, the composite resistance value r of resistors 13 to 15 may be selected from "0Ω", where signals B0 to B2 are all in a "0" level, to 700KΩ, where signals B0 to B2 are all in a "1" level, and may be fixed to the selected value. Namely, it is possible to select a pre-bias value from V/4 to V/7.5.

Frame signal FR is a signal for making the liquid crystal application voltage into an alternating current, and an alternating signal having a duty ratio of 1/2 is supplied when power down signal PD is "0".

During a period when frame signal FR is "1", first and second operational amplifiers 19 and 20 are rendered to be in an inactive state, whereas third and fourth operational amplifiers 21 and 22 are set to be in an active state. In this condition, P-channel transistor 28 is cut off, and N-channel transistor 29 is turned on. Therefore, output V1 has a "0" level, V2 has voltage level "V2L", and V3 has voltage level "V3L".

In contrast, during a period when frame signal FR is "0", first and second operation amplifiers 19 and 20 are set to an active state, whereas third and fourth operational amplifiers 21 and 22 become an inactive state. P-channel transistor 28 is turned on, and N-channel transistor 29 is cut off. Therefore, terminal V1 puts out voltage level "V1H", V2 puts out level "V2H", and V3 puts out level "V".

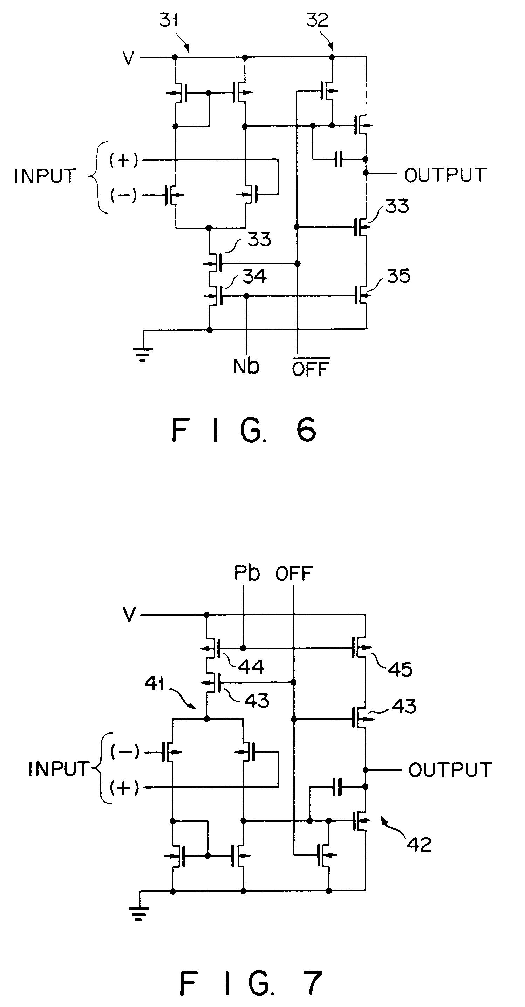

The relationship between frame signal FR and terminals V1 to V3 is shown in Fig. 5. In the example shown in Fig.5, resistance value R for resistors 11, 12 and resistors 16, 17 is set to be equal with composite resistance value r of resistors 13 to 15. What is shown in Fig.5 is an example in which intermediate voltage levels are obtained at a 1/5 pre-biased condition.

The structural examples of an operational amplifier in which an inactive state can be set in addition to those examples shown in Fig. 2 and Fig. 3 are shown in Fig. 6 and Fig. 7. In these figures, the parts corresponding to structural elements of Figs. 2 and 3 are denoted by the same numerals.

The power source device having the above structure makes it possible to obtain a display quality which is equal to that obtained by a liquid crystal driving power source circuit using as its buffers operational amplifiers OP1 to OP4 shown in Fig. 13, and to make its power consumption almost half of power consumption consumed by the circuit shown in Fig. 13. In a voltage dividing circuit shown in Fig. 8, at least four resistors (a group of r1, r4, R1 and R4, or a group of r2, r3, R2 and R3) must be simultaneously changed to change the pre-bias value to be applied to the liquid crystals, so that the amount of circuit elements will increase for performing a pre-bias value control by means of a software. In contrast, in a circuit shown in Fig. 1, the same purpose can be achieved only by changing a composite resistance value of resistors 13 to 15 using instruction signals B0 to B2. Therefore, the pre-bias value can be freely set by means of a software control function.

**Claims**

1. A power source apparatus for driving a liquid crystal display device, the apparatus comprising a voltage dividing circuit (18) for voltage-dividing a maximum voltage level "V" and a minimum voltage level "0" to generate a plurality of intermediate voltage levels "V2H", "V1H", "V3L", "V2L" needed for the liquid crystal display device, with a plurality of operational amplifiers (19 - 22) for outputting intermediate voltage levels as outputs V1 to V3, characterized in that
    a switching signal (FR) is provided for alternating-current-driving said liquid crystal display device and for setting a first group of said operational amplifiers into an active state and a second group of said operational amplifiers into an inactive state to reduce the circuit power consumption, and the operational amplifiers of the group which is set to the active state are arranged to output to segment electrodes and common electrodes of the liquid crystal display device.

2. An apparatus according to claim 1, characterized in that said voltage dividing circuit is formed of a plurality of resistors (11 - 17) serially coupled with each other, those resistors (13 - 15) that are arranged at a central portion of the plurality of resistors form a set of composite resistors, the plurality of resistors forming the composite resistors are each parallel coupled with a switching circuit, and a value of each of the composite resistors is variably set under control of the switching circuits.

3. An apparatus according to claim 1, characterized in that said voltage dividing circuit is formed of a first resistor (11), a second resistor (12), a third group of resistors (13 - 15), a fourth resistor (16), and a fifth resistor (17), all of which are serially connected with each other between the line for the maximum voltage level "V" and the line for the minimum voltage level "0", voltage outputs having intermediate voltage levels "V2H", "V1H", "V3L", and "V2L" are obtained from connecting points between each of the resistors and the group of resistors, and the voltage outputs are respectively supplied to the operational amplifiers (19 - 22).

4. An apparatus according to claim 3, characterized in that said group of resistors is formed of a plurality of resistors (13 - 15) which are respectively parallel connected with switching circuits (241 - 243), a composite resistance value of the third group of resistors is determined under control of the switching circuits so that a pre-bias value is determined.

5. An apparatus according to claim 1, characterized in that said plurality operational amplifiers are each formed to have a voltage follower structure in which their respective outputs return to their respective input sides.

6. An apparatus according to claim 1, characterized in that first stage input portions of the first group of operational amplifiers are formed of N-channel MOSFETs (36, 37), and first stage input portions of the second group of operational amplifiers are formed of P-channel MOSFETs (46, 47).

7. An apparatus according to claim 1, characterized in that said switching signal comprises a frame signal (FR) and means are provided for reversing the frame signal at every display frame unit.

8. An apparatus according to claim 1, characterized in that said operational amplifiers (19 - 22) are arranged to be in an inactive state in response to power down signals (PD) for instructing a condition that a display function of the liquid crystal display device is not used.

9. An apparatus according to claim 1, further comprising a bias voltage generator (27) for generating and supplying bias voltage to said operational amplifiers (19 - 22) as bias volatege, the bias voltage generator is set to be in an inactive condition by the power down signal (PD) which is generated under a condition that a display function of the liquid crystal display device is not used.

**Patentansprüche**

1. Speisequellengerät zum Steuern einer Flüssigkristall-Anzeigevorrichtung, wobei das Gerät umfaßt:
    - eine Spannungsteilerschaltung (18) zum Unterteilen der Spannung zwischen einem maximalen Spannungspegel "V" und einem minimalen Spannungspegel "0" zur Erzeugung einer Vielzahl von Zwischenspannungspegeln "V2H", V1H", "V3L", V2L", die für die Flüssigkristall-Anzeigevorrichtung benötigt werden, mit einer Vielzahl von Operationsverstärkern (19-22) zum Ausgeben von Zwischenspannungspegeln als Ausgaben V1 bis V3,
dadurch **gekennzeichnet,** daß

     - ein Schaltsignal (FR) zum Steuern der Flüssigkristall-Anzeigevorrichtung durch Wechselstrom und zum Setzen einer ersten Gruppe der Operationsverstärker in einen aktiven Zustand, sowie einer zweiten Gruppe der Operationsverstärker in einen inaktiven Zustand, vorgesehen ist, um den Schaltungsleistungsverbrauch zu reduzieren, wobei die Operationsverstärker der Gruppe, die in den aktiven Zustand versetzt ist, so angeordnet sind, daß sie an Segmentelektroden und gemeinsamen Elektroden der Flüssigkristall-Anzeigevorrichtung Spannungspegel ausgeben.

2. Gerät nach Anspruch 1,
dadurch **gekennzeichnet,** daß die Spannungsteilerschaltung aus einer Vielzahl von miteinander in Reihe geschalteten Widerständen (11-17) gebildet ist, wobei jene Widerstände (13-15), die in einem zentralen Abschnitt der Vielzahl der Widerstände angeordnet sind, eine Gruppe von zusammengesetzten Widerständen bilden, wobei die Vielzahl der die zusammengesetzten Widerstände bildenden Widerstände jeweils entsprechend parallel an einen Schaltkreis angeschlosssen sind, und wobei der Wert jeder der zusammengesetzten Widerstände durch die Steuerung der Schaltkreise variabel eingestellt wird.

3. Gerät nach Anspruch 1,
dadurch **gekennzeichnet,** daß die Spannungsteilerschaltung aus einem ersten Widerstand (11), einem zweiten Widerstand (12), einer dritten Gruppe von Widerständen (13-15), einem vierten Widerstand (16) und einem fünften Widerstand (17) gebildet ist, die alle zwischen der Leitung für den maximalen Spannungspegel "V" und der Leitung für den minimalen Spannungspegel "0" miteinander in Reihe geschaltet sind, wobei Spannungsausgaben, die Zwischenspannungspegel "V2H", V1H", "V3L" und "V2L" aufweisen, von Verbindungspunkten zwischen jedem der Widerstände und der Gruppe von Widerständen abgegriffen werden, und wobei die Spannungsausgaben jeweils entsprechend an die Operationsverstärker (19-22) geliefert werden.

4. Gerät nach Anspruch 3,
dadurch **gekennzeichnet,** daß die Gruppe von Widerständen aus einer Vielzahl von Widerständen (13-15) gebildet ist, die jeweils entsprechend parallel an Schaltkreise (241-243) angeschlossen sind, wobei der Wert eines zusammengesetzten Widerstandes der dritten Gruppe von Widerständen durch die Steuerung der Schaltkreise bestimmt wird, so daß ein Vorausvorspannungswert bestimmt wird.

5. Gerät nach Anspruch 1,
dadurch **gekennzeichnet,** daß jeder Verstärker der Vielzahl der Operationsverstärker so ausgebildet ist, daß er eine Spannungsfolgerstruktur aufweist, bei der ihre entsprechenden Ausgänge zu ihren entsprechenden Eingangsseiten zurückgeführt sind.

6. Gerät nach Anspruch 1,
dadurch **gekennzeichnet,** daß Eingangsabschnitte einer ersten Stufe der ersten Gruppe von Operationsverstärkern aus N-Kanal-MOSFETs (36, 37) gebildet sind, und daß Eingabeabschnitte der zweiten Gruppe von Operationsverstärkern aus P-Kanal-MOSFETs (46, 47) gebildet sind.

7. Gerät nach Anspruch 1,
dadurch **gekennzeichnet,** daß das Schaltsignal ein Bildsignal (FR) umfaßt, und daß Mittel vorgesehen sind, um das Bildsignal bei jeder Anzeigerahmeneinheit umzukehren.

8. Gerät nach Anspruch 1,
dadurch **gekennzeichnet,** daß die Operationsverstärker (19-22) so angeordnet sind, daß sie sich als Antwort auf Abschaltsignale (PD) in einem inaktiven Zustand befinden, um einen Zustand anzuweisen, bei dem eine Anzeigefunktion der Flüssigkristall-Anzeigevorrichtung nicht benutzt wird.

9. Gerät nach Anspruch 1,
das weiter einen Vorspannungsgenerator (27) zur Erzeugung und Lieferung einer Vorspannung an die Operationsverstärker (19-22) als Vorspannung aufweist, wobei der Vorspannungsgenerator so eingestellt ist, daß er durch das Abschaltsignal (PD) in einen aktiven Zustand versetzt wird, wobei das Signal unter der Bedingung erzeugt wird, daß die Anzeigefunktion der Flüssigkristall-Anzeigevorrichtung nicht benutzt wird.

**Revendications**

1. Appareil de source d'alimentation pour commander un dispositif d'affichage à cristaux liquides, l'appareil comprenant un circuit de division de tension (18) pour diviser en tension un niveau de tension maximum "V" et un niveau de tension minimum "0" pour générer une pluralité de niveaux de tension intermédiaires "V2H", "V1H", "V3L", "V2L", nécessaires pour le dispositif d'affichage à cristaux liquides, avec une pluralité d'amplificateurs opérationnels (19 à 22) pour fournir des niveaux de tension intermédiaires comme sorties V1 à V3, caractérisé en ce que

un signal de commutation (FR) est fourni pour commander en courant alternatif ledit dispositif d'affichage à cristaux liquides et pour metre un premier groupe desdits amplificateurs opérationnels dans un état actif et un second groupe desdits amplificateurs opérationnels dans un état inactif pour réduire la consommation d'énergie du circuit, et les amplificateurs opérationnels du groupe qui est mis dans l'état inactif sont disposés pour sortir sur les électrodes de segment et les électrodes de commun du dispositif d'affichage à cristaux liquides.

2. Appareil selon la revendication 1, caractérisé en ce que ledit circuit de division de tension est formé d'une pluralité de résistances (11 à 17) couplées en série l'une à l'autre, ces résistances (13 à 15) qui sont disposées sur une partie centrale de la pluralité de résistances forment un jeu de résistances composites, la pluralité de résistances formant les résistances composites sont chacune couplées en parallèle avec un circuit de commutation, et une valeur de chacune des résistances composites est réglée de façon variable sous la commande des circuits de commutation.

3. Appareil selon la revendication 1, caractérisé en ce que ledit circuit de division de tension est formé d'une première résistance (11), d'une seconde résistance (12), d'un troisième groupe de résistances (13 à 15), d'une quatrième résistance (16) et d'une cinquième résistance (17), dont toutes sont reliées en série les unes aux autres entre la ligne pour le niveau de tension maximum "V" et la ligne pour le niveau de tension minimum "0", des sorties de tension ayant des niveaux de tension intermédiaires "V2H", "V1H", "V3L", "V2L" sont obtenus à partir des points de liaison entre chacune des résistances et le groupe de résistances, et les tensions de sortie sont respectivement appliquées aux amplificateurs opérationnels (19 à 22).

4. Appareil selon la revendication 3, caractérisé en ce que ledit groupe de résistances est formé d'une pluralité de résistances (13 à 15) qui sont respectivement reliées en parallèle aux circuits de commutation (241 à 243), une valeur de résistance composite du troisième groupe de résistances est déterminée sous la commande des circuits de commutation de sorte qu'une valeur de pré-polarisation est déterminée.

5. Appareil selon la revendication 1, caractérisé en ce que chaque amplificateur opérationnel de ladite pluralité d'amplificateurs opérationnels est formée pour avoir une structure d'étage suiveur de tension dans laquelle leurs sorties respectives retournent à leurs côtés d'entrée respectifs.

6. Appareil selon la revendication 1, caractérisé en ce que des premières parties d'étage d'entrée du premier groupe d'amplificateurs opérationnels sont formées de MOSFETs à canal N (36, 37) et des premières parties d'étage d'entrée du second groupe d'amplificateurs opérationnels sont formées de MOSFETs à canal P (46, 47).

7. Appareil selon la revendication 1, caractérisé en ce que ledit signal de commutation comprend un signal de trame (FR) et des dispositifs sont fournis pour inverser le signal de trame sur chaque unité de trame d'affichage.

8. Appareil selon la revendication 1, caractérisé en ce que lesdits amplificateurs opérationnels (19 à 22) sont disposés pour être dans un état inactif en réponse aux signaux de mise hors service de l'alimentation (PD) pour informer d'une condition qu'une fonction d'affichage du dispositif d'affichage à cristaux liquides n'est pas utilisée.

9. Appareil selon la revendication 1 comprenant en outre un générateur de tension de polarisation (27) pour générer et fournir une tension de polarisation auxdits amplificateurs opérationnels (19 à 22) comme tension de polarisation, le générateur de tension de polarisation est mis dans un état inactif par le signal de mise hors service de l'alimentation (PD), qui est généré à condition qu'une fonction d'affichage du dispositif d'affichage à cristaux liquides ne soit pas utilisée.

F I G. 1

F I G. 2

F I G. 3

V

27

PD

Pb

Nb

F I G. 4

FR

V3 (V)
(V3L)
(O)

V2 (V)
(V2H)
(V2L)
(O)

V1 (V)
(VIH)
(O)

F I G. 5

F I G. 6

F I G. 7

F I G. 8

| FR | V1 | V2 | V3 |
|----|-----|-----|-----|
| O | V1H ($= \frac{3}{5}$ V) | V2H($= \frac{4}{5}$ V) | V |
| 1 | O | V2L($= \frac{1}{5}$ V) | V3L($= \frac{2}{5}$ V) |

F I G. 9

F I G. 10

F I G. 11

F I G. 13

FR

φC

V3　(V)
　　(V3L)
　　(O)

V2　(V)
　　(V2H)
　　(V2L)
　　(O)

V1　(V)
　　(VIH)
　　(O)

DISPLAY DATA

OUTPUT OF SEGMENT　(V)　(VIH)　(V3L)　(O)

COMMON SELECT

OUTPUT OF COMMON　(V)　(V2H)　(V2L)　(O)

F I G. 12